# EUROPEAN PATENT APPLICATION

(11) **EP 4 535 359 A2**
(43) Date of publication of application: **09.04.2025**
(21) Application number: 22315221.6
(22) Date of filing: 30.09.2022
(51) Int. Cl.: G11C 11/16

(54) **MAGNETIC MEMORY CELL BASED ON ORBITAL ANGULAR MOMENTUM**

(71) Applicant: Institute of Physics, 55099 Mainz (DE); Centre National de la Recherche Scientifique, 75016 Paris (FR)
(72) Inventor: Kläui, Mathias, 55122 MAINZ (DE); Bose, Arnab, 55131 MAINZ (DE); Drouard, Marc, 38240 MEYLAN (FR); Martin, Sylvain, 38240 MEYLAN (FR)
(74) Representative: IPAZ

(57) **Abstract**

An OAM-MRAM cell based on Orbital Angular Momentum (OAM) mechanism, comprising a tri-layer element (TRE) including a ferromagnetic pinned layer (Ferroₚ), a ferromagnetic free layer (Ferro_{f}), and a spacer (SP) interposed in-between, the MRAM cell further comprising an OAM structure (OAM_{Str}) adjacent to the ferromagnetic free layer and configured so that a writing current (Iw) flowing within the OAM structure can write a magnetic state of the ferromagnetic free layer by one of or by a combination of a first mechanism of injecting an orbital current induced by the OAM structure (OAM_{Str}) into the ferromagnetic free layer (Ferro_{f}) or a ferromagnetic writing layer (Ferro_{w}) adjacent thereto; and a second mechanism of injecting a spin current into the ferromagnetic free layer (Ferro_{f}) or a ferromagnetic writing layer (Ferro_{w}) adjacent thereto, the OAM structure being configured to induce an orbital current and to convert this orbital current into said spin current.

## Description

### FIELD OF THE INVENTION

The technical domain of the invention is that of Magnetoresistive Random Access Memory (MRAM) cells, that each comprises a Spin Valve (SV), such as a Magnetic Tunnel Junction (MTJ), whose magnetic state defines a bit of information, and more specifically that of MRAM cells making use of a layer adjacent and parallel to the MTJ to circulate a writing current in order to define the magnetic state of the Spin Valve.

### BACKGROUND OF THE INVENTION

Increased densities and reduction in die areas of embedded memories for cache applications, such as SRAM (Static Random Access Memory) and eDRAM (embedded Dynamic Random Access Memory) lead to increased static power consumption and reliability issues.

Alternatives emerge such as MRAMs (Magnetoresistive Random Access Memory), that are scalable, power efficient and fast enough to replace existing memory technologies (SRAM) at cache levels.

MRAMs are devices able to store bits of data by means of magnetization state in tri-layer elements.

A tri-layer element comprises a stack of two ferromagnetic layers separated by a non-magnetic spacer.

When the spacer is conductive the tri-layer element is called a Spin Valve (SV) and when the spacer is insulating the tri-layer element is called a Magnetic Tunnel Junction (MTJ).

The resistance of the tri-layer element (TLE)to electrical current passage is governed by quantum mechanical physics.

One of the two ferromagnetic layer has a pinned (or fixed) magnetization while the other one has a magnetization that can be oriented, and they are therefore often referred to as the pinned ferromagnetic layer (or fixed ferromagnetic layer, or also reference ferromagnetic layer) and the ferromagnetic free layer, respectively.

In an actual device, a tri-layer element (TLE)comprises other layers in addition to those cited so far, used to improve control over the physical properties of the device and/or inject currents therein and/or that are necessary for its manufacturing process.

A tri-layer element (TLE)exhibits two equilibrium states: a low-resistance state in which magnetizations of the two ferromagnetic layers are in a parallel state, i.e. magnetizations of both ferromagnetic layers are oriented towards a same direction, and a high-resistance state in which magnetizations of the two ferromagnetic layers are in an antiparallel state, i.e. magnetizations of the two ferromagnetic layers are respectively oriented towards two opposite directions.

Practically, an MRAM memory array comprises MRAM memory cells each comprising an MTJ in which these two states and their corresponding electrical resistance values are associated to bit values, "0" or "1".

These bit values are read by flowing an electrical current through the two ferroelectric layers of the tri-layer element (TLE) to determine its electrical resistance value, associated to a recorded bit value.

The ferromagnetic pinned layer is used as a reference ferromagnetic layer and its magnetization is stable over the lifetime of the device.

The ferromagnetic free layer can be written (i.e. its magnetization orientation can be controlled) at will by application of a current or a magnetic field.

Regarding the writing mechanism, one may cite three types of MRAMs: Field switching MRAM, Spin Transfer Torque MRAM (STT-MRAM) and Spin Orbit Torque MRAM (SOT-MRAM), that differ in their mechanisms for writing the ferromagnetic free layer.

In any implementation, an electrical current designated as "writing current" is used to write the state of the free ferromagnetic layer in the MTJ of each MRAM cell.

An active field of research in MRAMs consists in reducing the energy consumption of the writing current and improving the operation speed and the endurance or aging of the cell while preserving the retention efficiency of the memory bit in order to manufacture more efficient MRAM devices.

### OBJECT OF THE INVENTION

In the context described above, the inventors propose to make use of another mechanism to control the state of a ferromagnetic layer of an MRAM device: the Orbital Angular Momentum (OAM).

This mechanism relies on the properties of certain materials to generate an orbital current (I_{oc}) or a non-equilibrium orbital polarization accumulation (also termed non-equilibrium orbital angular momentum density) (Pₒ) through different physical phenomena such as the Orbital Hall Effect (OHE) and the Orbital Rashba Edelstein Effect (ORRE) (OREE)

This orbital angular momentum can induce a torque onto the magnetization of a ferromagnetic layer, thereby providing a way to control its magnetic state, see for example the article by Dongjoon Lee at al., "Orbital Torque in magnetic bilayers", Nature Communications (2021)12:6710.

One may also refer to the article by Shilei Ding et al., "Observation of the Orbital Rashba-Edelstein Magnetoresistance", in Physical Review Letters 128, n° 6 : 067201 published February 10, 2022.

The present invention aims at providing MRAM cells, designated as OAM-MRAM cells, for Orbital Angular Momentum-MRAM cells, that exploit the orbital angular momentum (OAM) to write the state of the ferromagnetic free layer of a tri-layer element (TLE) such as a magnetic tunnel junction or a spin-valve, and that have a reduced energy consumption for the writing current while preserving the advantages of conventional MRAM devices, and in particular compared to SOT-MRAM cells.

### SUMMARY OF THE INVENTION

To this effect, a first aspect of the invention relates to an OAM-MRAM cell based on Orbital Angular Momentum mechanism, comprising a tri-layer element including a ferromagnetic pinned layer, a ferromagnetic free layer, and a spacer interposed in-between, the MRAM cell being characterized by further comprising an OAM structure that is adjacent to the ferromagnetic free layer and that is configured so that a writing current , when flowing within the OAM structure, can write a magnetic state of the ferromagnetic free layer by either one of or by a combination of: (a) a first mechanism of injecting an orbital current (I_{OC}) induced by the OAM structure into the ferromagnetic free layer or a ferromagnetic writing layer adjacent thereto; and (b) a second mechanism of injecting a spin current (I_{SC}) into the ferromagnetic free layer or a ferromagnetic writing layer adjacent thereto, the OAM structure being configured to induce an orbital current and to convert this orbital current into said spin current.

According to further non limitative features of the first aspect of the invention, either taken alone or in any technically feasible combination:
- the OAM structure can comprise at least one OAM layer, an OAM layer being defined as a layer comprising at least one material presenting an orbital conductivity greater than 2×10³ (ℏ/e) (Ω.cm)⁻¹, or an oxide or an alloy of one or more of these materials or these oxides, and, where applicable, the OAM structure can comprise at least one SO layer that can convert the orbital current into the spin current, an SO layer being defined as a layer comprising at least one material presenting an orbital conductivity greater than 2×10³(ℏ/e) (Ω.cm)⁻¹, or an oxide or an alloy of one or more of these materials or these oxides;
- the OAM-MRAM cell can be configured so that writing of the magnetic state of the ferromagnetic free layer is carried out by at least the first mechanism, and the ferromagnetic free layer can comprise Ni and present a thickness comprised between 3 nm and 100 nm;
- the OAM-MRAM cell can be configured so that writing of the magnetic state of the ferromagnetic free layer is carried out by at least the first mechanism, and the ferromagnetic free layer can have a multilayer structure with a perpendicular magnetic anisotropy and presents a thickness comprised between 3 nm and 100 nm;
- the OAM-MRAM cell can be configured so that writing of the magnetic state of the ferromagnetic free layer is carried out by at least the first mechanism, and the ferromagnetic free layer can have a perpendicular magnetic anisotropy, an aspect ratio thickness/width greater than 1, and present a thickness comprised between 3 nm and 100 nm;
- the OAM-MRAM cell can be configured so that writing of the magnetic state of the ferromagnetic free layer is carried out by at least the first mechanism and a SOT mechanism, the OAM structure can comprise a ferromagnetic writing layer and a SOT layer distinct from the at least one OAM layer, the ferromagnetic writing layer being interposed between the at least one OAM layer and the SOT layer, a spin conductivity of the SOT layer and a spin conductivity of the at least one OAM layer can be of opposite signs;
- the OAM-MRAM cell can be configured so that writing of the magnetic state of the ferromagnetic free layer is carried out by at least the first mechanism and a SOT mechanism, the OAM structure can comprise a ferromagnetic writing layer, a SOT layer distinct from the at least one OAM layer, the ferromagnetic writing layer being interposed between the at least one OAM layer and the SOT layer, the SOT layer SOT_{lay} comprising a material presenting a spin conductivity greater than 0.3×10³(ℏ/e) (Ω.cm)⁻¹, the OAM structure can further comprise an additional ferromagnetic writing layer with the SOT layer interposed between the ferromagnetic writing layer and the additional ferromagnetic writing layer;
- the OAM-MRAM cell can be configured so that writing of the magnetic state of the ferromagnetic free layer is carried out by at least the second mechanism, the at least one SO layer being interposed between the at least OAM layer and the ferromagnetic free layer;
- the OAM-MRAM cell can be configured so that writing of the magnetic state of the ferromagnetic free layer is carried out by at least the second mechanism, the OAM structure can further comprise a ferromagnetic writing layer, an additional OAM layer, an additional SO layer, the additional OAM layer, the additional SO layer, the ferromagnetic writing layer, the SO layer and the at least one OAM layer overlapping each other in this order, and the SO layer and the additional SO layer can present orbital current to spin current conversion coefficients of opposite signs;
- the OAM-MRAM cell can be configured so that writing of the magnetic state of the ferromagnetic free layer is carried out by at least the second mechanism, the free ferromagnetic layer and the SOI layer of the OAM structure can be intermixed, either in the form of an alloy comprising at least one ferromagnetic material and a material having a spin orbit interaction coefficient greater than 0.02 Ry or in the form of a multilayer formed by a number of bi-layers, each comprising one SO layer comprising a materials having a spin orbit interaction greater than 0.02 Ry and one ferromagnetic free layers;

- the OAM-MRAM cell can be configured so that writing of the magnetic state of the ferromagnetic free layer is carried out by at least the first mechanism, and the ferromagnetic free layer can comprise a Co/Ni multilayer with a number of bilayers, each formed by a layer of Co adjacent to a layer of Ni, greater than 4;
- the OAM-MRAM cell can be configured so that writing of the magnetic state of the ferromagnetic free layer is carried out by at least the first mechanism, the OAM structure can comprise a plurality of OAM layers and a plurality of ferromagnetic writing layers, two consecutive ones of the OAM layers can have coefficients of orbital conductivity of opposite signs, and one or two of the OAM layers can be interposed between two consecutive ones of the ferromagnetic writing layers;
- the OAM-MRAM cell can be configured so that writing of the magnetic state of the ferromagnetic free layer is carried out by at least the second mechanism and a SOT mechanism, the OAM structure can further comprise a ferromagnetic writing layer, the at least one SO layer being interposed between the at least one OAM layer and the ferromagnetic writing layer, the OAM structure can further comprise a SOT layer, the ferromagnetic writing layer being interposed between the at least one SO layer and the SOT layer, and a spin conductivity of the SOT layer and a spin conductivity of a bilayer formed by the at least one OAM layer and the at least one SO layer can be of opposite signs;
- the OAM-MRAM cell can be configured so that writing of the magnetic state of the ferromagnetic free layer is carried out by both the first mechanism and the second mechanism, the OAM structure can further comprise a ferromagnetic writing layer, the at least one SO layer can be interposed between the OAM layer and the ferromagnetic writing layer, the OAM structure can comprise an additional OAM layer, the ferromagnetic writing layer being interposed between the SO layer and the additional OAM layer, and a spin conductivity of the additional OAM layer and a spin conductivity of a bilayer formed by the OAM layer and SO layer can be of opposite signs;
- the OAM-MRAM cell can be configured so that writing of the magnetic state of the ferromagnetic free layer is carried out by both of the first mechanism and the second mechanism, the OAM structure can comprises, a plurality of OAM layers, a plurality of SO layers, and a plurality of ferromagnetic writing layers, the OAM structure can comprise a multilayer formed from repeated tri-layers each comprising one of the ferromagnetic writing layers, one of the OAM layers, and one of the SO layers interposed between the one of the ferromagnetic writing layer and the one of the OAM layers.

### FIGURES

Many other features and advantages of the present invention will become apparent from reading the following detailed description, when considered in conjunction with the accompanying drawings, in which:
- Figure 1 illustrates a cross-section of the core structure of an OAM-MRAM cell according to the invention ;
- Figure 2 illustrates a part of fig. 1 into more details ;
- Figure 3 illustrates a first mechanism of operation and 1^{st}, 3^{rd} and 4^{th} configurations of the OAM structure of Fig. 2 ;
- Figure 4 illustrates a 5^{th} configuration of the OAM structure of Fig. 2 ;
- Figure 5 illustrates a 6^{th} configuration of the OAM structure of Fig. 2 ;
- Figure 6 illustrates a 7^{th} configuration of the OAM structure of Fig. 2 ;
- Figure 7 illustrates a second mechanism of operation and a 2^{nd} configuration of the OAM structure of Fig. 2 ;
- Figure 8 illustrates an 8^{th} configuration of the OAM structure of Fig. 2 ;
- Figure 9 illustrates an 9^{th} configuration of the OAM structure of Fig. 2 ;
- Figure 10 illustrates a 10^{th} configuration of the OAM structure of Fig. 2 ;
- Figure 11 illustrates an 11^{th} configuration of the OAM structure of Fig. 2 ;
- Figure 12 illustrates a 12^{th} configuration of the OAM structure of Fig. 2 ;
- Figure 13 illustrates a 13^{th} configuration of the OAM structure of Fig. 2 ; and
- Figure 14 illustrates a 14^{th} configuration of the OAM structure of Fig. 2.

The figures are schematic representations that, for the sake of clarity, are not drawn to scale and, in particular, thicknesses of layers are not to scale compared to lateral dimensions.

### DETAILED DESCRIPTION OF SPECIFIC EMBODIMENTS OF THE INVENTION

An OAM-MRAM cell according to the invention has an overall structure similar to that of an SOT-MRAM cell, with a tri-layer element (TLE) controlled by means of three electric terminals or to a SOT-assisted STT-MRAM cell, with a tri-layer element controlled by means of two or three electric terminals.

In a conventional SOT-MRAM, the magnetic state of the ferromagnetic free layer Ferro_{f} is written by relying on Spin Orbit Torques (SOT) that are induced by Spin Hall Effect (SHE) or Rashba-Edelstein effect (REE).

In contrast, in an OAM-MRAM cell according to the invention, the magnetic state of the ferromagnetic free layer Ferro_{f} is written by relying at least on Orbital Torques (OT) induced by orbital Hall effect(OHE).

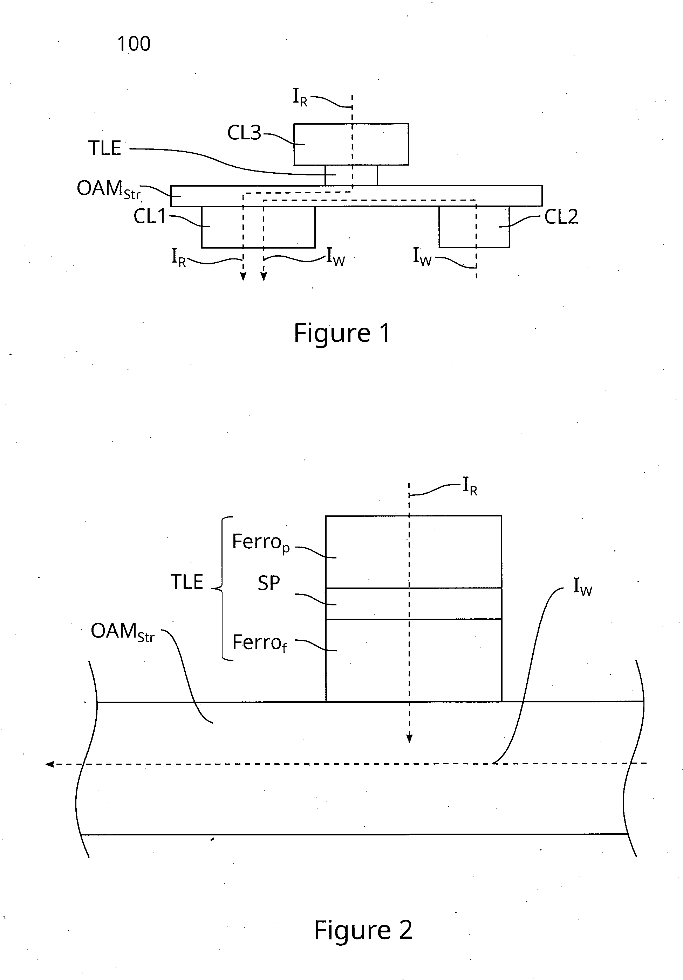

Fig. 1 illustrates an OAM-MRAM cell 100 with three terminals materialized respectively as electrically conductive layers CL1, CL2 and CL3 for connections with the circuitry controlling the cell: the first terminal is used for circulating both of a writing current I_{W} and a reading current I_{R}, and the second and the third terminals are dedicated each to one of the writing current I_{W} and the reading current I_{R}.

To control the magnetic state of the ferromagnetic free layer, an OAM-MRAM cell according to the invention includes a tri-layer element (TLE) comprising a ferromagnetic free layer Ferro_{f} and a pinned ferromagnetic layer Ferroₚ separated by a spacer SP, and an OAM structure OAM_{Str} adjacent to the ferromagnetic free layer Ferrof of the tri-layer element (TLE) as illustrated by Fig. 2, this OAM structure. OAM_{Str} being configured to generate the orbital torques upon circulation therein of a writing current Iw.

In the example illustrated by Fig. 1, the ensemble formed by the OAM structure OAM_{Str} and the TLE is interposed between first and the third terminals, and the first and the second terminals are on the same side of the OAM structure OAM_{Str}.

Still, as long as the reading current I_{R} can flow through the three elements (Ferroₚ, SP, Ferro_{f}) of the TRE and the writing current I_{W} can flow within the OAM structure OAM_{Str} alongside the ferromagnetic free layer Ferro_{f} as illustrated by Fig. 2, other geometries can be envisioned.

Although not represented in Figs. 1 and 2, a capping layer may be interposed between the tri-layer element (TLE) and the conductive line CL1 ; this capping layer can comprise an electrically conductive layer, an antiferromagnetic layer or a synthetic antiferromagnet (SAF) including a metallic non-magnetic spacer layer and a ferromagnetic layer or a plurality of such layers in alternating order; further, the cap layer may comprise any additional layer required by the practitioner to attain any specific functions and/or specifications for the OAM-MRAM cell.

The ferromagnetic layers Ferro_{f} and Ferroₚ can comprise a ferromagnetic material including a metal or alloy having a specific perpendicular magnetic anisotropy whereby magnetizations of these layers are oriented substantially vertically (perpendicular to the plane of the ferromagnetic layers, configuration known as out-of-plane or perpendicular magnetic anisotropy PMA).

Such metal or alloy can comprise FePt, FePd, CoPt, or a rare earth/transition metal alloy, in particular GdCo, TdFeCo, or Co, Fe, CoFe, Ni, CoNi, CoFeB, FeB.

Alternatively, the ferromagnetic layers Ferro_{f} and Ferroₚ can comprise a metal or alloy with magnetizations oriented parallel to the plane of the ferromagnetic layers Ferro_{f} and Ferroₚ (in-plane magnetic anisotropy).

Such metal or alloy can comprise FePt, FePd, CoPt, or a rare earth/transition metal alloy, in particular GdCo, TdFeCo, or Co, Fe, CoFe, Ni, CoNi, CoFeB, FeB.

The thickness of the ferromagnetic layers Ferro_{f} and Ferroₚ can be comprised between 0.5 nm and 100 nm and preferably between 1 and 3 nm.

In the case where the MRAM exploits the Giant Magnetoresistance (GMR) effect, the spacer in made on a non-magnetic electrically conducting layer, such layer can comprise Cu, Ru, Cr or other metallic conductors known to lend themselves to the GMR effect.

In the case where the MRAM exploits the Tunnel Magnetoresistance (TMR) effect, the spacer is a non-magnetic electrically insulating layer, for example an oxide layer such as an MgO layer of an Al₂O₃ layer.

### OAM structure

The OAM structure is represented in Fig. 1 as a monolithic element, but the OAM structure can be any of variety of complex structures, each adequate for generating and exploiting orbital torques to control the magnetic state of the ferromagnetic free layer Ferro_{f} in a specific way.

The orbital torques (OT) are magnetic torques that act on the magnetization of a ferromagnetic layer that are generated by a charge current I_{W} flowing within an OAM layer OAM_{lay} part of the OAM structure OAM_{Str}.

In this document, an OAM layer is a layer able to produce an orbital current I_{oc} by orbital Hall effect (OHE) or a non-equilibrium orbital angular momentum density Pₒ by orbital Rashba-Edelstein Effect (OREE).

This orbital current and this non-equilibrium orbital angular momentum density induce orbital torques (OT) that can be exploited to write the magnetic state of the ferromagnetic free layer.

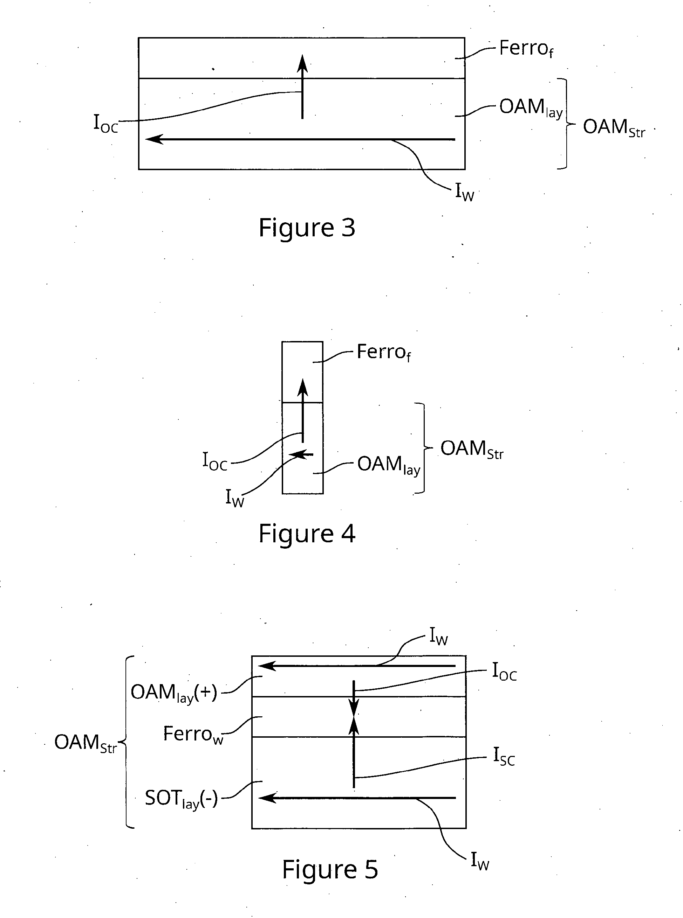

The orbital torques can either be applied directly to the magnetism of the ferromagnetic free layer Ferro_{f} of the tri-layer element TRE (see for example Fig. 3)', or can be applied to a ferromagnetic writing layer Ferro_{w} that is part of the OAM structure OAM_{Str} and that will write the state . of the ferromagnetic free layer Ferro_{f} by magnetic coupling (see for example Fig. 5).

In this document, a ferromagnetic writing layer Ferro_{w} is a ferromagnetic layer part of the OAM structure and whose magnetic state can be written similarly to the magnetic state of the ferromagnetic free layer.

By magnetic coupling, the ferromagnetic writing layer Ferro_{w} then writes the magnetic state of the ferromagnetic free layer Ferro_{f}; to this end, these layers have to be in sufficiently close proximity, as determined by the practitioner.

The OAM structure described in the configurations below can be put into direct contact with the ferromagnetic free layer Ferro_{f}, or through a separation layer, preferably an electrically conductive magnetic or non-magnetic layer no thicker than 2 nm, but depending on the nature of the magnetic coupling, thicker layers may be considered.

In the following, for the sake of conciseness, we will mention only the orbital current I_{OC}, but it is understood that non-equilibrium orbital angular momentum density Pₒ is produced concurrently for similar effects.

In the OAM-MRAM according to the invention, the orbital torques (OT) can be obtained according to two mechanisms.

### First mechanism - direct orbital current injection

In the first mechanism, the orbital current I_{oc} is injected as such into a ferromagnetic layer.

The ferromagnetic layer considered here may be either the ferromagnetic free layer Ferro_{f} of the tri-layer element (TLE)or another ferromagnetic layer, Ferro_{w}, acting onto the ferromagnetic free layer Ferro_{f} by magnetic coupling.

An orbital angular momentum is induced by the electrical current flowing within the OAM structure OAM_{Str} and absorbed in the ferromagnetic layer through spin-orbit interaction, resulting in orbital torques OT acting on the magnetization.

This is similar to the functioning of a SOT-MRAM, in which spin orbit torques SOT (resulting from the Spin Hall Effect or Rashba Edelstein effect) are used to govern the transition of the ferromagnetic free layer via spin current or spin accumulation.

However, in this first mechanism the ferromagnetic layer has to be able to absorb orbital angular momentum for conversion into magnetic torques through spin-orbit interaction (SOI).

Both effects, the orbital torques (OT) and the spin orbit torques (SOT), occur generally concurrently and are often difficult to disentangle from one another.

Still, they clearly have distinct physical effects through which they can be distinguished, for example by the fact that spin orbit torques act on all ferromagnets efficiently while orbital torques can exhibit strongly varying efficiencies for different ferromagnetic materials involved.

One may refer to the article of Dongjoon Lee at al., "Orbital Torque in magnetic bilayers", Nature Communications (2021)12:6710.

Further, materials and/or structures that are adequate to generate orbital torques OT from the OAM layer for practical applications are distinct from materials and/or structures that are adequate to generate spin orbit torques SOT as in SOT-MRAM.

The present patent application has for objective to present structures and materials adequate to generate efficiently orbital torques for practical application in the control of the magnetic of the ferromagnetic free layer of a tri-layer element (TLE) in an MRAM cell.

Theoretical considerations have lead the inventors of the present invention to the conclusion that, to be able to generate effectively the orbital torques, the OAM layer OAM_{lay} needs to comprise materials presenting an orbital conductivity σ_{OH} greater than 2×10³(ℏ/e) (Ω.cm)⁻¹, i.e. Sc, Ti, V, Cr, Mn, Fe, Co, Y, Zr, Nb, Mo, Tc, Ru, Rh, Lu, Hf, Ta, W, Re, Os, Ir, Pt, Au and preferably greater than 6×10³(ℏ/e) (Ω.cm)⁻¹, i.e. V, Cr, Mn, Fe, Co, Nb, Mo, Tc, Ru, Rh, Os, Ir (the values of σ_{OH} for various atoms can be found in the article by Leandro Salemi and Peter M. Oppeneer, "First-principles theory of intrinsic spin and orbital Hall and Nernst effects in metallic monoatomic crystals", arXiv:2203.17037); these materials can be used individually as such, as oxides or as alloys of these materials or these oxides, or as multilayers of these materials, oxides or alloys.

The orbital conductivity can be determined, for example, by ST-FMR or harmonic Hall voltage measurements.

### Second mechanism - orbital current conversion into spin current

In the second mechanism, the orbital angular momentum carried by the orbital current is not directly absorbed by the ferromagnetic layer itself but is converted into a spin angular momentum carried by a spin current by an additional SO layer SO_{lay} that is interposed between the OAM layer OHE_{lay} and the ferromagnetic layer and into which the spin current is injected.

As in the first mechanism, the ferromagnetic layer considered here may be either the ferromagnetic free layer Ferro_{f} of the tri-layer element or another ferromagnetic layer, Ferro_{w}, acting onto the ferromagnetic free layer Ferro_{f} by magnetic coupling.

In this document, a SO layer is a layer whose spin orbit interaction induces the conversion of an orbital current I_{OC} into a spin current I_{SC}, or, otherwise stated, the conversion of an orbital angular momentum into a spin angular momentum.

The conversion is operated by Spin Orbit Interaction (SOI) in the SO layer SO_{lay}, thus, for practical applications, the SO layer SO_{lay} needs to comprise materials having a spin orbit interaction coefficient greater than 0.02 Ry, or heavy metals such W, Pt, Ta, Mo, Bi, and Hf or topological insulators such as Bi2Se3, BiSb and WTe2, for example ; these materials can be used individually as such, as oxides or as alloys of these materials or these oxides, or as multilayers of these materials, oxides or alloys.

The spin orbit interaction coefficient can be predicted from ab-initio computation or determined by indirect measurements using lateral spin valve, ST-FMR or harmonic Hall voltage measurements.

With both the first and the second mechanisms, taken alone or in combination, a substantial enhancement in the effectiveness of the writing current I_{W} can be achieved, with an immediate reduction in current consumption and heating as compared to other types of MRAMs.

### OAM structure - 1^{st} configuration - 1^{st} mechanism

In this configuration, illustrated by Fig. 3, the OAM structure of Fig. 2 makes use of the first mechanism and comprises an OAM layer OAM_{lay}, the ferromagnetic free layer Ferro_{f} being here in direct contact with the OAM layer OAM_{lay}.

This OAM structure is configured to make use of the first mechanism, so that the writing current (I_{W}), when flowing within the OAM structure (OAM_{Str}), can write a magnetic state of the free ferromagnetic free layer Ferro_{f} by injecting an orbital current I_{OC} generated by the OAM layer OAM_{lay}, directly into the ferromagnetic free layer Ferro_{f}.

The current I_{W} flows within the OAM layer, thus alongside, or substantially in parallel to, the ferromagnetic free layer, so that the generated orbital current I_{OC} flows perpendicularly to the ferromagnetic free layer and is injected therein.

In this document, the expression "in parallel to a layer" means parallel to a plane in which the layer extends, i.e. perpendicular to a direction normal a surface on which the layer is deposited.

This orbital current is absorbed by the ferromagnetic free layer through spin-orbit interaction which results in the writing of the magnetic state of the ferromagnetic free layer by the generated orbital torques (OT) acting on its magnetization, as described in the article by Dongwook et al., "Orbital torque: Torque generation by orbital current injection", in Phys. Rev. Research 2, 013177 - published February 20, 2020.

### OAM structure - 2^{nd} configuration - 2^{nd} mechanism

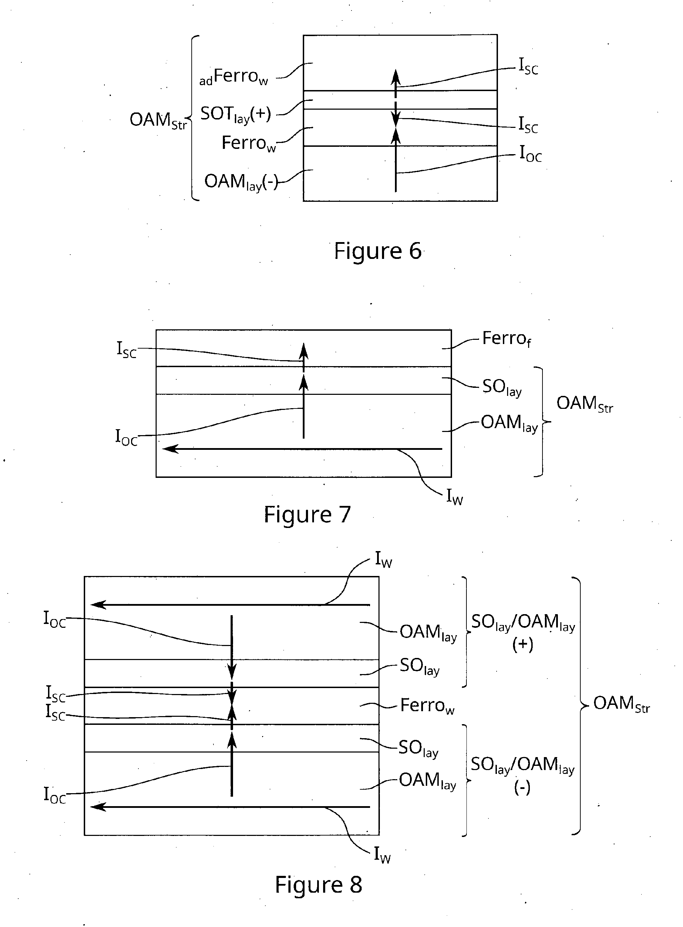

In this configuration, illustrated by Fig. 7, the OAM structure of Fig. 2 makes use of the second mechanism and thus comprises both an OAM layer OHE_{lay} and an SO layer SO_{lay} interposed between the ferromagnetic free layer Ferro_{f} and the OAM layer OHE_{lay}.

The OAM structure is configured to make use of the second mechanism, so that the writing current I_{W}, when flowing within the OAM structure OAM_{Str}, can write a magnetic state of the free ferromagnetic free layer Ferro_{f} by firstly generating an orbital current in an OAM layer OHE_{lay}, then converting this orbital current I_{OC} into a spin current I_{SC} via an SO layer SO_{lay} through a spin orbit interaction SOI mechanism, injecting the spin current I_{SC} into the ferromagnetic free layer Ferro_{f} and applying a spin-orbit torque SOT to the magnetization of the ferromagnetic free layer Ferro_{f}.

### OAM structure - 3^{rd} configuration

This configuration is derived from the 1^{st} configuration that makes use of the first mechanism, and one may refer to Fig. 3 for illustration.

The specificity here is that the ferromagnetic free layer is made to efficiently absorb the orbital current I_{OC} by comprising Ni and having a thickness comprised between 3 nm and 100 nm, preferably between 6 nm and 10 nm.

In addition to a positive effect to the current absorption, such thickness imparts a good thermal stability to the ferromagnetic free layer.

### OAM structure - 4^{th} configuration

This configuration is derived from the first configuration that makes use of the first mechanism with corresponding advantages, and one may refer to Fig. 3 for illustration.

The specificity here is that the ferromagnetic free layer presents intrinsic Perpendicular Magnetic Anisotropy PMA, which can be achieved by forming the ferromagnetic free layer as a multilayer of Co/Ni, Tb/Co or Co/Pt bi-layers.

This configuration may also be applied to the ferromagnetic free layer of the 2^{nd} configuration, for example with one layer of the bi-layers having the-function of the SO layer SO_{lay}.

### OAM structure - 5^{th} configuration

This configuration is derived from the 1^{st} configuration that makes use of the first mechanism.

In this configuration, illustrated by Fig. 4, the ferromagnetic free layer Ferro_{f} has a perpendicular magnetic anisotropy, an aspect ratio thickness/width greater than 1 that may favorize the apparition of perpendicular magnetization thanks to the shape anisotropy, and presents a thickness comprised between 3 nm and 100 nm.

This configuration may also be applied to the ferromagnetic free layer of the 2^{nd} configuration.

Such a configuration allows formation of tri-layer elements (TLE) of small lateral dimensions and relatively high thickness, with advantages in terms of memory density and thermal stability.

### OAM structure - 6^{th} configuration

This OAM structure is configured to combine the first mechanism and a Spin Orbit Torque SOT mechanism, for a more efficient writing of the magnetic state of the ferromagnetic free layer.

In this configuration, the OAM structure OAM_{Str} of Fig. 2 is illustrated by Fig. 5 and comprises a SOT layer SOT_{lay} distinct from the OAM layer OAM_{lay}, a ferromagnetic writing layer Ferro_{w} being interposed between the OAM layer OAM_{lay} and the SOT layer SOT_{lay}.

The SOT mechanism designates spin orbit torques, and a SOT layer is defined as a layer configured to produce a spin current, I_{SC} upon circulation of a charge current parallel to and within the SOT layer, of a magnitude and a sign function of a spin conductivity of the material constituting the SOT layer.

Here, an orbital current I_{OC} generated by the OAM layer OAM_{lay} and a spin current I_{SC} generated by the SOT layer SOT_{lay} each apply a respective torque to the magnetization of the ferromagnetic writing layer Ferro_{w}.

For these two torques to have effects that add-up instead of cancelling one another, the spin conductivity of the SOT layer and the spin conductivity of the OAM layer are of opposite signs, as illustrated by the symbols "+" and "-" associated to the layers OAM_{lay} and SOT_{lay} in Fig. 5.

Still, as is the case throughout this document, these symbols do not indicate the sign of the coefficients in a real structure, they merely illustrate the opposition in signs regarding the conductivities mentioned above.

Further, to be of practical effectiveness, it is preferable for the SOT layer SOT_{lay} to comprise at least one material presenting an spin conductivity σ_{SH} greater than 0.3×10³(ℏ/e) (Ω.cm)⁻¹, i.e. Ni, Rh, Pd, Ir and Pt, or greater than 0.8×10³(ℏ/e) (Ω.cm)⁻¹; these materials can be used individually as such, as oxides or as alloys of these materials or these oxides, or as multilayers of these materials, oxides or alloys.

The spin conductivity can be determined, for example, by ST-FMR or harmonic Hall voltage measurements.

An OAM structure having the present configuration and in which the OAM layer, the ferromagnetic free layer and the SO layer being respectively made of Ru, a multilayer of Co/Ni and Pt can be given as example.

### OAM structure - 7^{th} configuration

Similarly to the 6^{th} configuration, this OAM structure is configured to combine the first mechanism and a SOT mechanism, as illustrated by Fig. 6 that shows the OAM structure of Fig. 2.

For the characteristics of the SOT layer and its properties relatively to the OAM layer, one may refer to the explanations regarding the 6^{th} configuration.

The specificity here is that an additional ferromagnetic free layer _{ad}Ferro_{w} is added, so that the SOT layer SOT_{lay} is interposed between the ferromagnetic writing layer Ferro_{w} and the additional ferromagnetic writing layer Ferro_{w}, so that the SO layer is able to influence the magnetization of both ferromagnetic layers by spin orbit torques.

From a technological point of view, the SOT layer helps growing a thick composite ferromagnet composed of the two ferromagnetic writing layers by isolating the crystal structures of these two ferromagnet writing layers from one another so that the additional ferromagnetic writing layer can be easily grown on top of the ferromagnetic free layer.

Also, the ferromagnetic free layer Ferro_{f} may constitute the additional ferromagnetic writing layer, in which case the tri-layer element TRE and the OAM structure OAM_{Str} are intermixed.

An exemplary structure is the following, the OAM layer, the ferromagnetic writing layer, the SOT layer and the additional ferromagnetic writing layer are respectively made of Ru, Ni, W and CoFeB.

### OAM structure - 8^{th} configuration

This configuration is derived from the 2^{nd} configuration illustrated by Fig. 7 and thus makes use of the second mechanism detailed above and is illustrated by Fig. 8.

Compared to the OAM structure of Fig. 7, the OAM structure of this configuration further comprises an additional SO layer SO_{lay} and an additional OAM layer OAM_{lay}, so as to obtain a symmetric structure with a ferromagnetic writing layer Ferro_{w} (instead of the ferromagnetic free layer Ferro_{f}) sandwiched between the two SOI layers and the obtained tri-layer sandwiched between the two OAM layers.

In other words, the additional OAM layer OAM_{lay}, the additional SO layer SO_{lay}, the ferromagnetic writing layer Ferro_{w}, the SO layer SO_{lay} and the OAM layer OAM_{lay} overlap each other in this order.

With this structure, orbital currents I_{OC} are generated by the OAM layers, injected into the respective SO layers that convert them into spin orbit currents I_{SC} injected into the ferromagnetic writing layer where they apply respective torques to the magnetization of this layer.

For these two torques to have effects that add-up instead of cancelling one another, the spin conductivity of the bilayers SO_{lay}/OAM_{lay} each formed on a side of the ferromagnetic writing layer are of opposite signs, as illustrated by the symbols "+" and "-" associated in Fig. 8.

Still, these symbols do not indicate the sign of the coefficients in a real structure, they merely illustrate the opposition in signs regarding the coefficients mentioned above.

These signs can be determined for example by ST-FMR or Harmonic Hall voltage measurements.

In an exemplary structure of this configuration, the OAM layers are made of Ru, the ferromagnet writing layer is made of a multilayer from by Co/Ni bilayers, one of the SO layer is made of Pt while the other SO layer is made of W.

This configuration is advantageous in that the writing effect is enhanced thanks to the injection of spin current from both sides of the ferromagnetic free layer.

### OAM structure - 9^{th} configuration

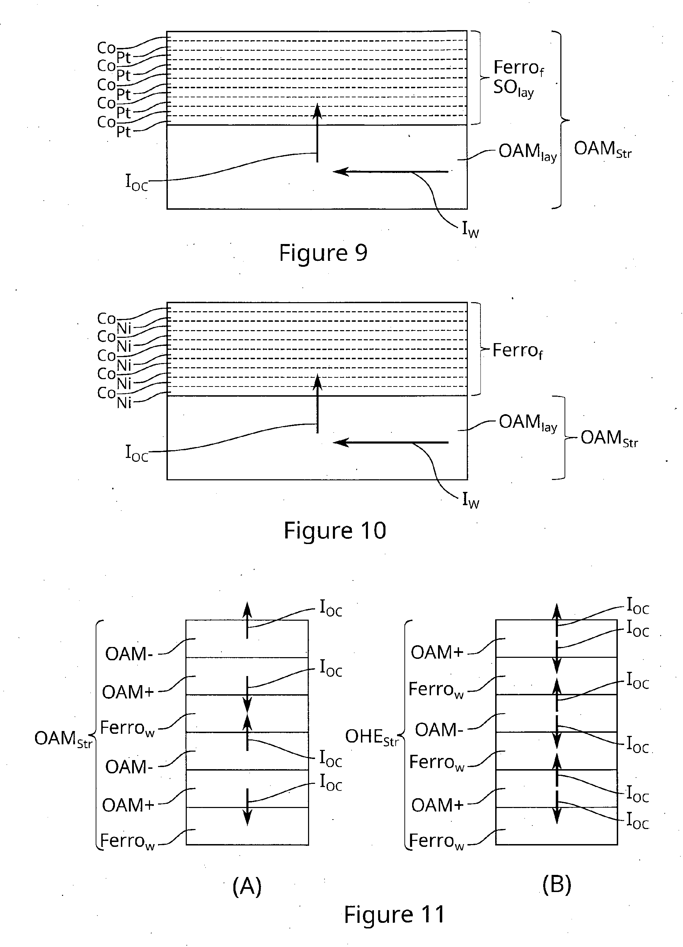

This configuration is a variant of the 2^{nd} configuration illustrated by Fig. 7 that makes use of the second mechanism and is illustrated by Fig. 9.

The free ferromagnetic layer Ferro_{f} and the SO layer SO_{lay} of the OAM structure OAM_{Str} are intermixed, either in the form of an alloy comprising at least one ferromagnetic material and a materials having a spin orbit interaction coefficient greater than 0.02 Ry and a ferromagnetic material, or in the form of a multilayer formed by a number of bi-layers, each comprising one SO layer SO_{lay} comprising a materials having a spin orbit interaction coefficient greater than 0.02 Ry and one ferromagnetic layer.

In the case of a multilayer, it is preferable that the number of bi-layers be greater than 3 for a better absorption of the injected orbital current.

Here, each of the SO layers will individually participate in writing the state of the ferromagnetic free layer according to the second mechanism describe above.

Practical examples of the alloy and the bi-layer are a CoPt alloy and Co/Pt bi-layer, respectively, that can be associated with an OAM layer made of Ru.

Within the multilayer and the alloy, the material having a spin orbit interaction, such as Pt, can convert orbital currents to spin currents, thereby writing the magnetic state of the ferromagnetic free layer.

Fig. 9 illustrates the configuration with a Co/Pt multilayer, with the Pt layers indicated as Pt have the function of SO layers and the Co layers indicated as Co have the function of ferromagnetic layers.

### OAM structure - 10^{th} configuration

This configuration is derived from the first configuration that makes use of the first mechanism and is illustrated by Fig. 10.

Here, the ferromagnetic free layer is made of a Co/Ni multilayer comprising a number of bi-layers, each formed by a layer of Co adjacent to a layer of Ni, respectively indicated as co and Ni in Fig. 10, greater than 4, 5 in Fig. 10.

Such a configuration can be applied to any of the previous configurations, with the advantages that Ni is highly efficient to absorb the torque imparted by the orbital current, the Co/Ni multilayer presents an intrinsic perpendicular magnetic anisotropy which is favorable to the OAM-MRAM memory dots density and can be very thick.

### OAM structure - 11^{th} configuration

This OAM structure is configured to make use of the first mechanism.

In this configuration, the OAM structure OAM_{Str} Fig. 2 comprises a plurality of OAM layers (OAM+, OAM-) and a plurality of ferromagnetic writing layers Ferro_{w} that can be distributed according to the two variants (A) and (B) illustrated by Fig. 11.

In both variants, the ferromagnetic writing layers Ferro_{w} are sandwiched between two consecutive OAM layers having spin conductivity of opposite signs, OAM layers having a positive spin conductivity (indicated as OAM+) alternating with OHA layers having a negative spin conductivity (indicated as OAM-).

This is to ensure that the effect of the orbital current I_{OC} that are injected in any given ferromagnetic writing layer have effects that add-up and not effects cancelling each other.

These signs can be determined for example by ST-FMR or harmonic Hall voltage measurements.

In Fig. 11, only the orbital currents having a significant effect onto the ferromagnetic writing layers are represented, orbital current generated by one OAM layer and injected directly in an adjacent OAM layer being largely absorbed or cancelled prior to reaching the next ferromagnetic writing layer.

In variant (A), two OAM layers having spin conductivity of opposite signs (OHE+, OHE-) are adjacent to each other and interposed between two consecutive ferromagnetic writing layers Ferro_{w}.

In variant (B), OHA layers OHE+ and OHE- are individually sandwiched between two consecutive ferromagnetic writing layers Ferro_{w}.

### OAM structure - 12^{th} configuration

Thi's OAM structure is configured to write a magnetic state of a ferromagnetic writing layer Ferro_{w} by combining the second mechanism and a spin orbit torque (SOT) mechanism, for a more efficient writing of the magnetic state of the ferromagnetic free layer Ferro_{f}.

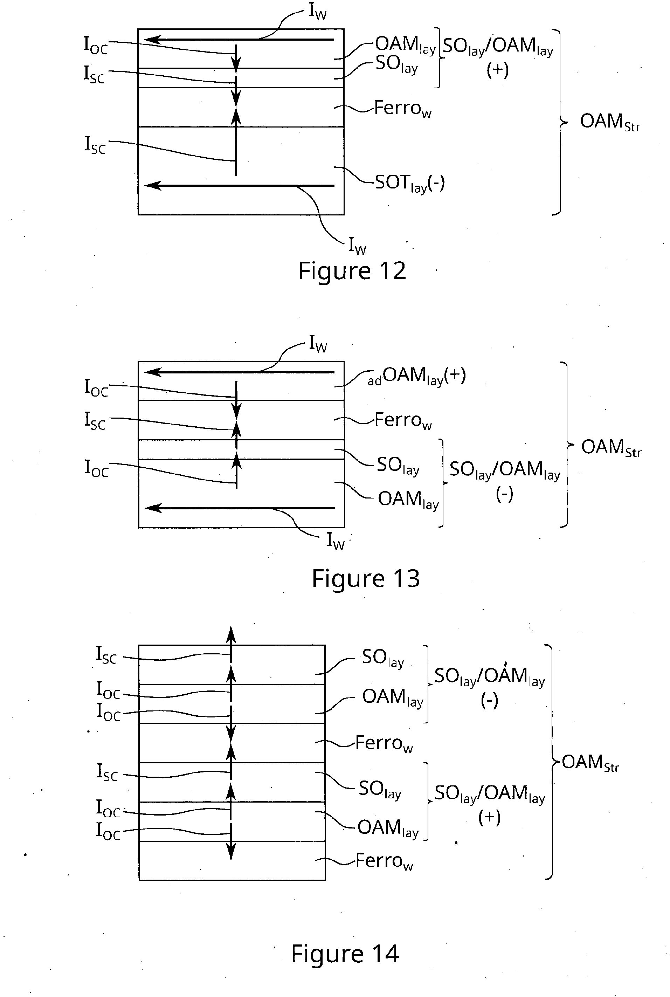

In this configuration, the OAM structure OAM_{Str} of Fig. 2 is illustrated by Fig. 12 and comprises a SOT layer SOT_{lay} distinct from the OAM layer OAM_{lay} and the SO layer SO_{lay} used to make use of the second mechanism as explained in the 2^{nd} configuration and illustrated by Fig. 7.

A ferromagnetic writing layer Ferro_{w} is interposed between the SO layer SO_{lay} and the SOT layer SOT_{lay}, the SO layer SO_{lay} being interposed between the ferromagnetic writing layer Ferro_{w} and the OAM layer OAM_{lay}.

Overall, the functioning and advantages of this configuration are similar to those of the 6^{th} configuration illustrated by Fir. 5, with the difference that the second mechanism (conversion of an orbital current into a spin current for injection into the ferromagnetic free layer) is used instead of the first mechanism (direct injection of an orbital current into the ferromagnetic free layer).

The function of the SOT layer is to generate a spin current I_{SC} to be injected into the ferromagnetic writing layer Ferro_{w} and to apply a torque on its magnetization in addition to the torque applied by the spin current I_{SC} generated by the SO layer by conversion of an orbital current I_{OC} generated by the OAM layer.

For these two torques to have effects that add-up instead of cancelling one another, the spin conductivity of the SOT layer SOT_{lay} and the spin conductivity of the bilayer formed by the OAM layer OAM_{lay} and SO layer SO_{lay} are of opposite signs, as illustrated by the symbols "+" and "-" associated to the layers SOT_{lay} and the bilayer SO_{lay}/OAM_{lay} in Fig. 12.

These signs can be determined for example by ST-FMR or harmonic Hall voltage measurements.

Still, these symbols do not indicate the sign of the coefficients in a real structure, they merely illustrate the opposition in signs regarding the coefficients mentioned above.

An OAM structure having the present configuration and in which the OAM layer, the SO layer, the ferromagnetic writing later and the SOT layer being respectively made of Ru, Pt, Co or a multilayer of Co/Ni, and Pt can be given as example.

### OAM structure - 13^{th} configuration

This OAM structure is configured to write the magnetic state of the ferromagnetic free layer Ferro_{f} via a ferromagnetic writing layer Ferro_{w} by using both of the first mechanism and the second mechanism, as illustrated by Fig. 13.

In this structure, the SOI layer (SOI_{lay}) is interposed between the OAM layer (OAM_{lay}) and the ferromagnetic free layer (Ferro_{f}), and the ferromagnetic free layer (Ferro_{f}) is interposed between the SOI layer (SOI) and an additional OAM layer (_{ad}OAM_{lay}).

Here, the first mechanism is applied between the additional OAM layer and the ferromagnetic free layer, and the second mechanism is applied between the OAM layer, the SOI layer and the ferromagnetic free layer, as described previously by injection, respectively of an orbital current I_{OC} and a spin current I_{SC} into the ferromagnetic free layer.

The currents I_{OC} and I_{SC} apply respective torques to the magnetization of the ferromagnetic free layer, and for these torques to have effects that add-up instead of cancelling one another, the spin conductivity of the additional OAM layer _{ad}OAM_{lay} and the spin conductivity of the bilayer formed by the OAM layer OAM_{lay} and SO layer SO_{lay} are of opposite signs, as illustrated by the symbols "+" and "-" associated to the layers _{ad}OAM_{lay} and the bilayer SO_{lay}/OAM_{lay} in Fig. 13.

Still, these symbols do not indicate the sign of the coefficients in a real structure, they merely illustrate the opposition in signs regarding the coefficients mentioned above.

### OAM structure - 14^{th} configuration

This OAM structure is configured to write the magnetic state of the ferromagnetic free layer Ferro_{f} by using both of the first mechanism and the second mechanism, as illustrated by Fig. 14.

This OAM structure comprises a plurality of OAM layers OAM_{lay}, a plurality of SO layers SO_{lay}, and a plurality of ferromagnetic writing layers Ferro_{w} in the form of a multilayer structure formed from repeated tri-layers each comprising one of the ferromagnetic free layers Ferro_{w}, one of the OAM layers OAM_{lay}, and one of the SO layers SO_{lay} interposed between the one of the ferromagnetic writing layer Ferro_{w} and the OAM layer OAM_{lay}.

With this structure, orbital currents I_{OC} are generated by the OAM layers, injected into the respective SO layers that convert them into spin orbit currents I_{SC} injected into the ferromagnetic writing layers where they apply respective torques to the magnetization of these layers.

For these two torques to have effects that add up instead of cancelling one another, the spin conductivity of the OAM layer alone and the bilayer formed by the OAM and SO layers are of opposite signs, as illustrated by the symbols "+" and "-" associated to the bilayers SO_{lay}/OAM_{lay} in Fig. 14.

Still, these symbols do not indicate the sign of the coefficients in a real structure, they merely illustrate the opposition in signs regarding the coefficients mentioned above.

In Fig. 14, for the sake of keeping the drawing easy to understand, only the orbital currents having preponderant effects onto the ferromagnetic free layers are represented, orbital current generated by one SO layer and injected directly in an adjacent OAM layer being at least partly absorbed or cancelled prior to reaching the next ferromagnetic free layer.

In this document, when it is mentioned that writing of the magnetic state of a ferromagnetic layer (Ferro_{f} or Ferro_{w}) is carried out by either one or a combination of a first mechanism of injecting a first orbital current generated by an OAM structure into this ferromagnetic layer and a second mechanism of injecting a spin current into this ferromagnetic layer by converting a second orbital current generated by the OAM structure into a spin current by a SO layer comprised in the OAM structure, it is implied that the writing would not be possible without the contribution of said orbital currents.

In other words, other mechanisms susceptible of applying a torque on the magnetism of the ferromagnetic free layer may exist concurrently with said orbital currents, such as a spin current or a non-equilibrium spin accumulation generated by spin orbit torques.

Also, the various structures described in this document may each comprise seed layers, spacer layers and so on that could have for purpose to help in the proper depositions of the other layers, in particular with regards to their crystalline structure, as people of ordinary skilled in the art are well aware of.

Each of the examples and embodiments mentioned in this document can be freely combined within technical limits understood by the practitioner in the field of the invention.

Other variations to the disclosed embodiments can be understood and effected by those skilled in the art in practicing the claimed invention, from a study of the drawings, the disclosure, and the appended claims.

## Claims

1. An OAM-MRAM cell (100) based on Orbital Angular Momentum (OAM) mechanism, comprising a tri-layer element (TRE) including a ferromagnetic pinned layer (Ferroₚ), a ferromagnetic free layer (Ferro_{f}), and a spacer (SP) interposed in-between,
the MRAM cell (100) being **characterized by** further comprising an OAM structure (OAM_{Str}) that is adjacent to the ferromagnetic free layer (Ferro_{f}) and that is configured so that a writing current (I_{W}), when flowing within the OAM structure (OAM_{Str}), can write a magnetic state of the ferromagnetic free layer (Ferro_{f}) by either one of or by a combination of:
a first mechanism of injecting an orbital current (I_{OC}) induced by the OAM structure (OAM_{Str}) into the ferromagnetic free layer (Ferro_{f}) or a ferromagnetic writing layer (Ferro_{w}) adjacent thereto; and
a second mechanism of injecting a spin current (I_{SC}) into the ferromagnetic free layer (Ferro_{f}) or a ferromagnetic writing layer (Ferro_{w}) adjacent thereto, the OAM structure (OAMStr) being configured to induce an orbital current (I_{OC}) and to convert this orbital current (I_{OC}) into said spin current (I_{SC}).

2. An OAM-MRAM cell according to claim 1,
wherein the OAM structure comprises at least one OAM layer (OAM_{lay}), an OAM layer being defined as a layer comprising at least one material presenting an orbital conductivity greater than 2×10³(ℏ/e) (Ω.cm)⁻¹, or an oxide or an alloy of one or more of these materials or these oxides, and
wherein, where applicable, the OAM structure (OAM_{Str}) comprises at least one SO layer (SO_{lay}) that can convert the orbital current (I_{OC}) into the spin current (I_{SC}), an SO layer being defined as a layer comprising at least one material presenting an orbital conductivity greater than 2×10³(ℏ/e) (Ω.cm)^{- 1}, or an oxide or an alloy of one or more of these materials or these oxides.

3. An OAM-MRAM cell according to claim 1, configured so that writing of the magnetic state of the ferromagnetic free layer (Ferro_{f}) is carried out by at least the first mechanism,
wherein the ferromagnetic free layer comprises Ni and presents a thickness comprised between 3 nm and 100 nm.

4. An OAM-MRAM cell according to claim 1, configured so that writing of the magnetic state of the ferromagnetic free layer (Ferro_{f}) is carried out by at least the first mechanism,
wherein the ferromagnetic free layer has a multilayer structure with a perpendicular magnetic anisotropy and presents a thickness comprised between 3 nm and 100 nm.

5. An OAM-MRAM cell according to claim 1, configured so that writing of the magnetic state of the ferromagnetic free layer (Ferro_{f}) is carried out by at least the first mechanism,
wherein the ferromagnetic free layer has a perpendicular magnetic anisotropy, an aspect ratio thickness/width greater than 1, and presents a thickness comprised between 3 nm and 100 nm.

6. An OAM-MRAM cell according to claim 2, configured so that writing of the magnetic state of the ferromagnetic free layer (Ferro_{f}) is carried out by at least the first mechanism and a SOT mechanism,
wherein the OAM structure (OAM_{Str}) comprises a ferromagnetic writing layer (Ferro_{w}) and a SOT layer (SOT_{lay}) distinct from the at least one OAM layer (OAM_{lay}), the ferromagnetic writing layer (Ferro_{w}) being interposed between the at least one OAM layer (OAM_{lay}) and the SOT layer (SOT_{lay}),
wherein a spin conductivity of the SOT layer (SOT_{lay}) and a spin conductivity of the at least one OAM layer (OAM_{lay}) are of opposite signs.

7. An OAM-MRAM cell according to claim 2, configured so that writing of the magnetic state of the ferromagnetic free layer (Ferro_{f}) is carried out by at least the first mechanism and a SOT mechanism,
wherein the OAM structure (OAM_{Str}) comprises a ferromagnetic writing layer (Ferro_{w}), a SOT layer (SOT_{lay}) distinct from the at least one OAM layer (OAM_{lay}), the ferromagnetic writing layer (Ferro_{w}) being interposed between the at least one OAM layer (OAM_{lay}) and the SOT layer (SOT_{lay}), the SOT layer SOT_{lay} comprising a material presenting a spin conductivity greater than 0.3×10³(ℏ/e) (Ω.cm)⁻¹,
wherein the OAM structure (OAM_{Str}) further comprises an additional ferromagnetic writing layer (_{ad}Ferro_{w}) with the SOT layer interposed between the ferromagnetic writing layer and the additional ferromagnetic writing layer (_{ad}Ferro_{f}).

8. An OAM-MRAM cell according to claim 2, configured so that writing of the magnetic state of the ferromagnetic free layer (Ferro_{f}) is carried out by at least the second mechanism, the at least one SO layer (SO_{lay}) being interposed between the at least OAM layer (OAM_{lay}) and the ferromagnetic free layer (Ferro_{f}).

9. An OAM-MRAM cell according to claim 2, configured so that writing of the magnetic state of the ferromagnetic free layer (Ferro_{f}) is carried out by at least the second mechanism, wherein the OAM structure (OAM_{Str}) further comprises a ferromagnetic writing layer (Ferro_{w}), an additional OAM layer (OAMlay), an additional SO layer (SO_{lay}),
wherein the additional OAM layer (OAM), the additional SO layer (SO), the ferromagnetic writing layer (Ferro_{w}), the SO layer (SO_{lay}) and the at least one OAM layer (OAM_{lay}) overlap each other in this order, and
the SO layer (SO) and the additional SO layer (SO) present orbital current to spin current conversion coefficients of opposite signs.

10. An OAM-MRAM cell according to claim 2, configured so that writing of the magnetic state of the ferromagnetic free layer (Ferro_{f}) is carried out by at least the second mechanism,
wherein the free ferromagnetic layer and the SOI layer of the OAM structure (OAM_{Str}) are intermixed, either in the form of an alloy comprising at least one ferromagnetic material and a material having a spin orbit interaction coefficient greater than 0.02 Ry or in the form of a multilayer formed by a number of bi-layers, each comprising one SO layer (SO_{lay}) comprising a materials having a spin orbit interaction greater than 0.02 Ry and one ferromagnetic free layers (Ferro_{f}).

11. An OAM-MRAM cell according to claim 1, configured so that writing of the magnetic state of the ferromagnetic free layer (Ferro_{f}) is carried out by at least the first mechanism,
wherein the ferromagnetic free layer comprises a Co/Ni multilayer with a number of bilayers, each formed by a layer of Co adjacent to a layer of Ni, greater than 4.

12. An OAM-MRAM cell according to claim 2, configured so that writing of the magnetic state of the ferromagnetic free layer (Ferro_{f}) is carried out by at least the first mechanism,
wherein the OAM structure comprises a plurality of OAM layers (OAM+, OAM-) and a plurality of ferromagnetic writing layers (Ferro_{w}),
wherein two consecutive ones of the OAM layers (OAM+, OAM-) have coefficients of orbital conductivity of opposite signs, and
wherein one or two of the OAM layers (OAM+, OAM-) are interposed between two consecutive ones of the ferromagnetic writing layers (Ferro_{w}).

13. An OAM-MRAM cell according to claim 2, configured so that writing of the magnetic state of the ferromagnetic free layer (Ferro_{f}) is carried out by at least the second mechanism and a SOT mechanism,
wherein the OAM structure (OAM_{Str}) further comprises a ferromagnetic writing layer (Ferro_{w}), the at least one SO layer (SO_{lay}) being interposed between the at least one OAM layer (OAM_{lay}) and the ferromagnetic writing layer (Ferro_{w}),
wherein the OAM structure (OAM_{Str}) further comprises a SOT layer (SOT_{lay}), the ferromagnetic writing layer (Ferro_{w}) being interposed between the at least one SO layer (SO_{lay}) and the SOT layer (SOT_{lay}), and
wherein a spin conductivity of the SOT layer (SOT_{lay}) and a spin conductivity of a bilayer (SO_{lay}/OAM_{lay}) formed by the at least one OAM layer (OAM_{lay}) and the at least one SO layer (SO_{lay}) are of opposite signs.

14. An OAM-MRAM cell according to claim 2, configured so that writing of the magnetic state of the ferromagnetic free layer (Ferro_{f}) is carried out by both the first mechanism and the second mechanism,
wherein the OAM structure (OAM_{Str}) further comprises a ferromagnetic writing layer (Ferro_{w}),
wherein the at least one SO layer (SO_{lay}) is interposed between the OAM layer (OAM_{lay}) and the ferromagnetic writing layer (Ferro_{w}),
wherein the OAM structure comprises an additional OAM layer (_{ad}OAM_{lay}), the ferromagnetic writing layer (Ferro_{w}) being interposed between the SO layer (SO_{lay}) and the additional OAM layer (_{ad}OAM_{lay}), and
wherein a spin conductivity of the additional OAM layer (_{ad}OHE_{lay}) and a spin conductivity of a bilayer (SO_{lay}/OAM_{lay}) formed by the OAM layer (OAM_{lay}) and SO layer (SO_{lay}) are of opposite signs.

15. An OAM-MRAM cell according to claim 2, configured so that writing of the magnetic state of the ferromagnetic free layer (Ferro_{f}) is carried out by both of the first mechanism and the second mechanism,
wherein the OAM structure (OAM_{Str}) comprises a plurality of OAM layers (OAM_{lay}), a plurality of SO layers (SO_{lay}), and a plurality of ferromagnetic writing layers (Ferro_{w}),
wherein the OAM structure comprises a multilayer formed - from repeated tri-layers each comprising one of the ferromagnetic writing layers (Ferro_{w}), one of the OAM layers (OAM_{lay}), and one of the SO layers (SO_{lay}) interposed between the one of the ferromagnetic writing layer (Ferro_{w}) and the one of the OAM layers (OAM_{lay}).
